# EUROPEAN PATENT SPECIFICATION

(11) **EP 3 089 043 B1**
(45) Date of publication and mention of the grant of the patent: **30.12.2020**
(21) Application number: 14891927.7
(22) Date of filing: 16.05.2014
(51) Int. Cl.: G06F 13/14, G06F 13/40, H04W 84/10, H01Q 1/22

(54) **CABINET SERVER AND DATA CENTER BASED THEREON**
SCHRANKSERVER SOWIE DARAUF BASIERENDES DATENCENTER
SERVEUR-ARMOIRE ET CENTRE DE DONNÉES BASÉ SUR CELUI-CI

(43) Date of publication of application: 02.11.2016
(73) Proprietor: Huawei Technologies Co. Ltd., Shenzhen, Guangdong 518129 (CN)
(72) Inventor: CHEN, Shaojie, Shenzhen Guangdong 518129 (CN); WEI, Zhulin, Shenzhen Guangdong 518129 (CN); ZHAO, Junfeng, Shenzhen Guangdong 518129 (CN); HE, Rui, Shenzhen Guangdong 518129 (CN); DONG, Xiaowen, Shenzhen Guangdong 518129 (CN); LIN, Peng, Shenzhen Guangdong 518129 (CN); YANG, Wei, Shenzhen Guangdong 518129 (CN)
(74) Representative: Körber, Martin Hans
(86) International application number: PCT/CN2014/077670
(87) International publication number: WO 2015/172381

(56) References cited:
- CN-A- 102 436 610
- CN-A- 103 098 038
- CN-U- 203 276 314
- GB-A- 2 398 407
- US-A1- 2006 234 787
- US-A1- 2011 243 074
- US-A1- 2013 107 853
- US-A1- 2013 215 876

## Description

### TECHNICAL FIELD

The present invention relates to a network architecture, and in particular, to a cabinet server and a data center based on the cabinet server.

### BACKGROUND

A data center generally refers to a system that implements functions such as data centralized processing, data exchange, and data management within physical space. With development of technologies and advancement of the society, more data is generated, and a data center is increasingly important.

From a perspective of hardware composition, existing data centers generally include two types, that is, a wired data center and a wireless data center. The wired data center includes multiple cabinet servers centered on data processing and cables connecting components within the cabinet servers. As a communication passage between the cabinet servers and between the components within the cabinet servers, the cables are generally relatively large in quantity. The wired data center has problems of a bad maintainability and a bad fault-tolerance capability due to the large quantity of cables. In addition, scattered cables block a ventilation channel and cause bad heat sink performance. To resolve the problems, the wireless data center is widely applied. Because the wireless data center performs communication in a wireless manner, the foregoing problems of the wired data center can be well resolved.

However, the inventor finds in the study process of this application that, in the prior art, a radio signal is generally horizontally transmitted while a radio signal transmission is performed in a wireless data center, and electromagnetic radiation generated by the radio signal causes electromagnetic interference to electronic devices in the wireless data center, and affects service lives of the electronic devices and transmission quality of the radio signal.

US 2013/0107853 A1 discloses a system and method of wirelessly communicating in a backplane mesh network, using millimeter wave antennas which communicate within a cabinet or across spaced cabinets. US 2006/0234787 A1 introduces a system and method for transmitting wireless signals between components housed within a faraday-like cage structure which prohibits electromagnetic waves from entering from or radiating out to an ambient environment. The wireless signals propagate horizontally within a backplane area.

### SUMMARY

The present invention discloses a cabinet server according to independent claim 1 and a data center based on the cabinet server according to independent claim 9, so as to resolve a problem in the prior art that when a wireless data center performs communication, generated radiation affects a service life of an electronic device and transmission quality of a radio signal.

To resolve the foregoing technical problem, the present invention discloses the following technical solutions:
According to a first aspect, a cabinet server is provided, where the cabinet server includes at least two function nodes, multiple intra-cabinet antennas, and multiple inter-cabinet antennas, where
the function nodes are vertically arranged, to form a server core, where the server core includes multiple function node layers, and each function node layer includes at least one function node;
the intra-cabinet antennas are vertically arranged and are disposed at a side of the server core, an intra-cabinet antenna corresponding to each function node has a frequency needed by the corresponding function node, the intra-cabinet antenna and the corresponding function node are electrically connected, and adjacent intra-cabinet antennas are wirelessly connected; and
when a radio signal is transmitted within the cabinet server, each intra-cabinet antenna is configured to transmit, after receiving the radio signal, the radio signal to a vertically adjacent intra-cabinet antenna, until the radio signal is transmitted to a target intra-cabinet antenna of the multiple intra-cabinet antennas, and the target intra-cabinet antenna transmits the radio signal to a function node that is electrically connected to the target intra-cabinet antenna, so that the function node analyzes and processes the radio signal and wherein a hollow cavity is formed between adjacent function nodes.

With reference to the first aspect, in a first possible implementation manner of the first aspect, the cabinet server further includes a wireless data controller, and the wireless data controller is disposed outside the server core and is connected to an intra-cabinet antenna disposed at a top layer and an inter-cabinet antenna;
each inter-cabinet antenna is disposed at a top of the server core;
when the radio signal is transmitted between the cabinet server and another cabinet server, after obtaining the radio signal, the intra-cabinet antenna disposed at the top layer transmits the radio signal to the wireless data controller, and the wireless data controller transmits the radio signal to the connected inter-cabinet antenna; and
the inter-cabinet antenna is configured to receive the radio signal transmitted by the wireless data controller and transmit the radio signal to the another cabinet server; and receive a radio signal transmitted by another cabinet server, and transmit, to the wireless data controller connected to the inter-cabinet antenna, the radio signal transmitted by the another cabinet server, so that the wireless data controller transmits, to the intra-cabinet antenna at the top layer, the radio signal transmitted by the another cabinet server.

With reference to the first implementation manner of the first aspect, in a second possible implementation manner of the first aspect, the cabinet server further includes:
a wireless shield layer, where the wireless shield layer wraps the outside of the server core; and
the intra-cabinet antennas, the inter-cabinet antennas, and the wireless data controller are disposed outside the wireless shield layer.

With reference to the second implementation manner of the first aspect, in a third possible implementation manner of the first aspect, the cabinet server further includes:
an antenna backplane, where the antenna backplane is disposed outside the wireless shield layer and configured to fasten the intra-cabinet antenna.

With reference to the second implementation manner of the first aspect, in a fourth possible implementation manner of the first aspect, the cabinet server further includes:
an extension plate, where the extension plate is disposed outside the wireless shield layer, is disposed in parallel with the function nodes, and is configured to fasten the intra-cabinet antenna.

With reference to the first aspect, in a fifth possible implementation manner of the first aspect, the function nodes include:
a computing node, a memory node, a storage node, and an input/output node.

With reference to the first possible implementation manner of the first aspect, in a sixth possible implementation manner of the first aspect, the cabinet server further includes:
a bottom inter-cabinet antenna disposed at a bottom of the server core; and
a bottom wireless data controller that is disposed at the bottom of the server core and that is connected to the bottom inter-cabinet antenna, where the bottom wireless data controller is connected to a function node at a bottom layer; and
the bottom wireless data controller is configured to: after receiving a radio signal transmitted by the function node at the bottom layer, transmit the radio signal to the bottom inter-cabinet antenna, so that the bottom inter-cabinet antenna transmit the radio signal to another cabinet server; and after receiving a radio signal transmitted by the bottom inter-cabinet antenna, transmit the radio signal to the bottom inter-cabinet antenna.

With reference to any one of the first to the sixth possible implementation manner of the first aspect, in a seventh possible implementation manner of the first aspect, the cabinet server further includes:
rack top antennas disposed above the intra-cabinet antenna disposed at the top layer, where the rack top antennas and the intra-cabinet antennas are vertically arranged, the rack top antennas and the intra-cabinet antennas at the top layer are wirelessly connected, and the rack top antennas and the wireless data controller are connected; and
the rack top antenna is configured to receive a radio signal transmitted by the intra-cabinet antenna at the top layer and transmit the radio signal to the wireless data controller; and receive a radio signal transmitted by the wireless data controller and then transmit the radio signal to the intra-cabinet antenna at the top layer.

According to a second aspect, a data center is provided, where the data center includes:
the cabinet server according to the first aspect or to any one of the first to the seventh implementation manner of the first aspect.

With reference to the second aspect, in a first possible implementation manner of the second aspect,
in the data center, adjacent cabinet servers are wirelessly connected by using an inter-cabinet antenna.

The present invention discloses a cabinet server and a data center based on the cabinet server. The cabinet server includes at least two function nodes, multiple intra-cabinet antennas, and multiple inter-cabinet antennas. The function nodes are vertically arranged, to form a server core, where the server core includes multiple function node layers, and each function node layer includes at least one function node. The intra-cabinet antennas are vertically arranged, disposed at a side of the server core, and electrically connected to corresponding function nodes, and adjacent intra-cabinet antennas are wirelessly connected.

When a radio signal is transmitted within a cabinet by using the cabinet server disclosed in the present invention, after receiving a radio signal, an intra-cabinet antenna in the cabinet server transmits the radio signal to a vertically adjacent intra-cabinet antenna, so as to implement transmission of the radio signal between adjacent intra-cabinet antennas. A transmission path of the radio signal is formed of vertically arranged intra-cabinet antennas. Because intra-cabinet antennas are disposed at a side of a server core formed of function nodes, electromagnetic radiation generated by the radio signal in a transmission process has a relatively small effect on the function nodes, thereby reducing the effect of the electromagnetic radiation on various electronic devices in the function nodes, improving service lives of the electronic devices, and improving transmission quality of the radio signal.

### BRIEF DESCRIPTION OF DRAWINGS

To describe the technical solutions in the embodiments of the present invention or in the prior art more clearly, the following briefly describes the accompanying drawings required for describing the embodiments or the prior art. Apparently, the accompanying drawings in the following description show merely some embodiments of the present invention, and a person of ordinary skill in the art may still derive other drawings from these accompanying drawings without creative efforts.
FIG. 1 is a schematic structural diagram of a cabinet server disclosed in the prior art;
FIG. 2 is a schematic structural diagram of a processing module of a cabinet server disclosed in the prior art;
FIG. 3 is a schematic diagram of intra-group transmission performed by a processing module of a cabinet server disclosed in the prior art;
FIG. 4 is a schematic cross-sectional diagram of a cabinet server during intra-group transmission in a cabinet server disclosed in the prior art;
FIG. 5 is a schematic cross-sectional diagram of a cabinet server during inter-group transmission in a cabinet server disclosed in the prior art;
FIG. 6 is a front view of an architecture of a cabinet server disclosed in the present invention;
FIG. 7 is a side view of a structure of a cabinet server disclosed in the present invention;
FIG. 8 is a side view of a structure of another cabinet server disclosed in the present invention;
FIG. 9 is a schematic architectural diagram of a computing node disclosed in the present invention;
FIG. 10 is a schematic architectural diagram of a memory node disclosed in the present invention;
FIG. 11 is a schematic diagram of transmitting a radio signal by using a cabinet server disclosed in the present invention;
FIG. 12 is a schematic architectural diagram of a wireless data controller disclosed in the present invention; and
FIG. 13 is a schematic architectural diagram of a data center disclosed in the present invention.

### DESCRIPTION OF EMBODIMENTS

The following embodiments of the present invention provide a cabinet server and a data center, so as to resolve a problem in the prior art that electromagnetic radiation affects a service life of an electronic device in a wireless data center and transmission quality of a radio signal.

To make a person skilled in the art understand the technical solutions in the embodiments of the present invention better, and make the objectives, features, and advantages of the embodiments of the present invention clearer, the following further describes the technical solutions in the embodiments of the present invention in detail with reference to the accompanying drawings.

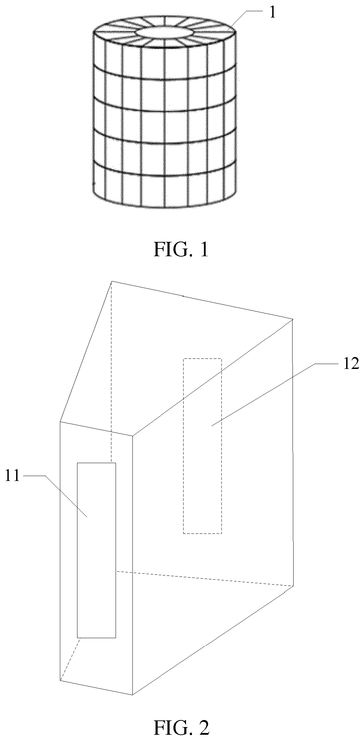

In the prior art, a used wireless data center generally includes multiple cabinet servers. Referring to a schematic structural diagram shown in FIG. 1, each cabinet server includes multiple processing modules 1. The processing modules 1 are generally set to have a wedge shape. Wedge-shape processing modules 1 at a same horizontal plane are arranged into a shape of a circular ring. A center of the circular ring is a spare area. Multiple layers of processing modules 1 are arranged into a cylinder, thereby constructing a cabinet server. A structure of the processing module 1 is shown in FIG. 2. The processing module 1 is provided with communications elements configured to transmit a radio signal. The communications elements include an intra-group communications element 11 and an inter-group communications element 12. The intra-group communications element 11 is disposed at an inner surface of the processing module 1, and the inter-group communications element 12 is disposed at an outer surface of the processing module 1. Moreover, each communications element may emit an electromagnetic energy beam that is focused in a particular direction.

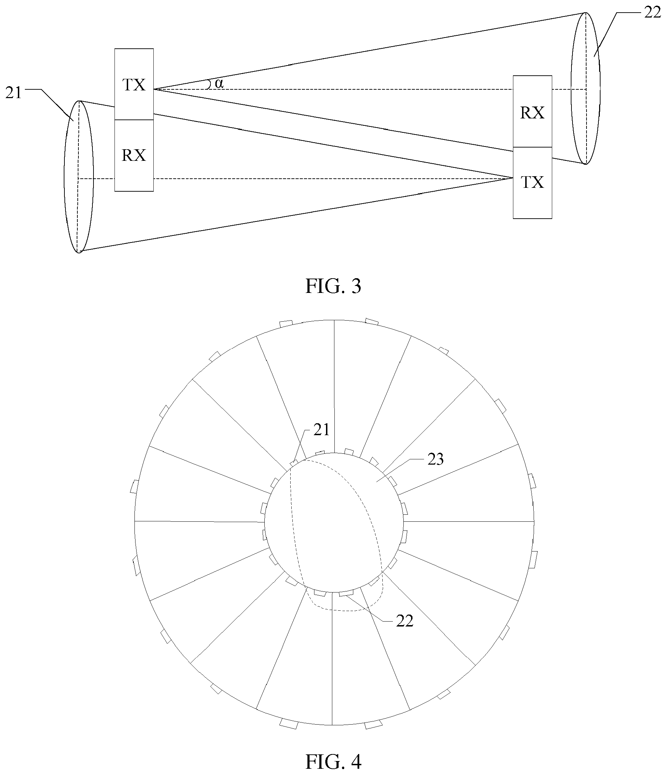

Referring to FIG. 3, when radio signal intra-group transmission is performed, a first intra-group communications element 21 emitting a radio signal obtains a radio signal in a form of an electromagnetic energy beam by using a sending module (Transmit Xmt, TX), and transmits the radio signal to a receiving module (Receive Xmt, RX) of a second intra-group communications element 22 within coverage of the electromagnetic energy beam by using a spare area. Refer to a cross-sectional view of a cabinet server shown in FIG. 4. A center of the cabinet server is a spare area 23. A first intra-group communications element 21 transmits a radio signal in a form of an electromagnetic energy beam to a second intra-group communications element 22 by using the spare area 23, thereby implementing radio signal intra-group transmission.

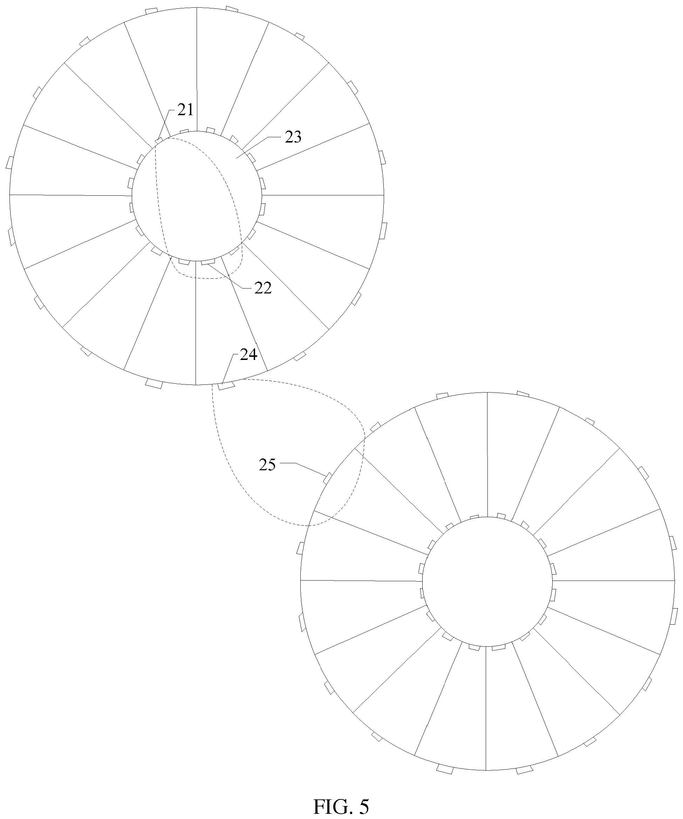

When radio signal inter-group transmission is performed, a cross-sectional view of two cabinet servers performing radio signal transmission is shown in FIG. 5. A second intra-group communications element 22 receiving a radio signal transmits the radio signal to a second inter-group communications element 24 corresponding to the processing module, and the second inter-group communications element 24 transmits the radio signal to a processing module of another cabinet server in a form of an electromagnetic energy beam. A third inter-group communications element 25 disposed at the processing module of the another cabinet server receives the radio signal, so as to implement radio signal inter-group transmission.

However, it can be learned according to the foregoing descriptions that when a radio signal is transmitted by using a wireless data center, the radio signal generates electromagnetic radiation, the radio signal is horizontally transmitted in a processing module in a form of an electromagnetic energy beam, and the electromagnetic radiation generated by the radio signal causes electromagnetic interference to an electronic device in the processing module, thereby affecting a service life of the electronic device and transmission quality of the radio signal.

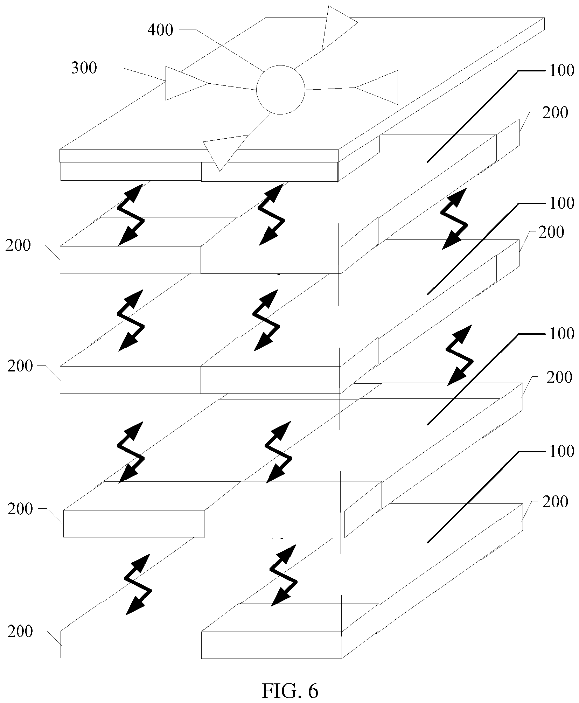

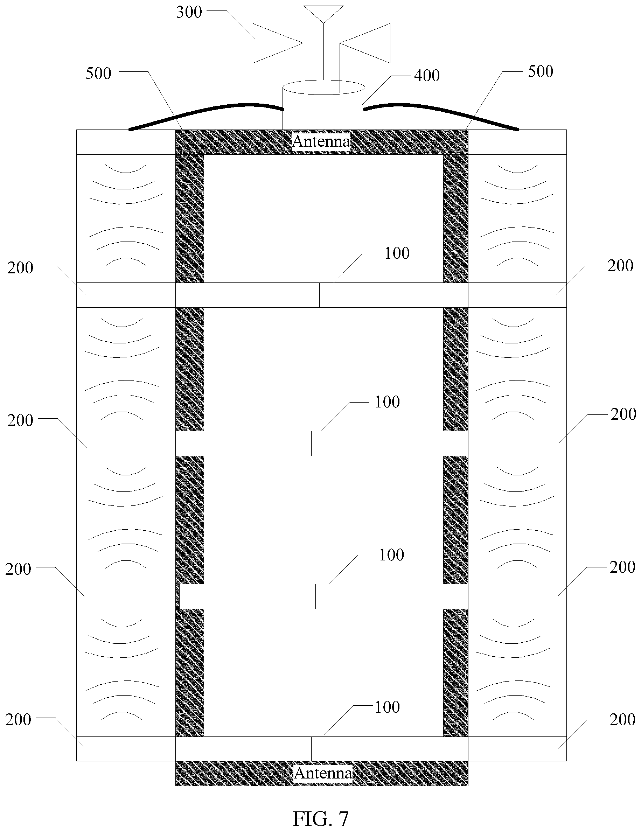

To reduce interference of electromagnetic radiation to an electronic device and improve a service life of the electronic device and transmission quality of a radio signal, this application discloses a cabinet server. FIG. 6 is a front view of an architecture of a cabinet server disclosed in this application. FIG. 7 is a side view of a structure of a cabinet server disclosed in this application.

Referring to FIG. 6 and FIG. 7, the cabinet server includes at least two function nodes 100, multiple intra-cabinet antennas 200, and multiple inter-cabinet antennas 300.

The function nodes 100 are vertically arranged, to form a server core, where the server core includes multiple function node layers, and each function node layer includes at least one function node 100. In this application, a solution in which the server core is decoupled into multiple function nodes 100 is used, so that a user decouples the server core into needed function nodes according to an application requirement, thereby implementing maximization of flexible resource configuration. In an actual application, according to an application requirement, the server core may be decoupled into multiple different function nodes. For example, a computing node, a memory node, a storage node, and an I/O (Input/Output, input/output) node may be configured in the server core. Correspondingly, radio signals received and sent by different function nodes are varied. For example, when the computing node, the memory node, the storage node, and the I/O node are configured in the server core, radio signals received and sent by the function nodes are correspondingly computing request data, memory data, storage data, and I/O data. The function nodes may include one or more processing modules in the prior art.

The intra-cabinet antennas 200 are vertically arranged and are disposed at a side of the server core, an intra-cabinet antenna 200 corresponding to each function node 100 has a frequency needed by the corresponding function node 100, the intra-cabinet antenna 200 and the corresponding function node 100 are electrically connected, and adjacent intra-cabinet antennas 200 are wirelessly connected. The adjacent intra-cabinet antennas 200 are wirelessly connected, so that a radio signal is transmitted between intra-cabinet antennas that are vertically adjacent.

The intra-cabinet antenna 200 may be connected to the function node 100 in a one-to-one correspondence. In this case, the intra-cabinet antenna 200 that is in a one-to-one correspondence with the function node 100 has a frequency needed by the function node 100. In addition, if a same intra-cabinet antenna includes frequencies needed by two or more function nodes, the two or more function nodes may be connected to the intra-cabinet antenna having multiple needed frequencies.

The intra-cabinet antenna transmits a radio signal in a frequency division multiplexing manner.

When a radio signal is transmitted within the cabinet server, each intra-cabinet antenna 200 is configured to transmit, after receiving the radio signal, the radio signal to a vertically adjacent intra-cabinet antenna 200, until the radio signal is transmitted to a target intra-cabinet antenna of the multiple intra-cabinet antennas 200, and the target intra-cabinet antenna transmits the radio signal to a function node 100 that is electrically connected to the target intra-cabinet antenna, so that the function node 100 analyzes and processes the radio signal.

When the radio signal is transmitted within the cabinet server, if the intra-cabinet antenna 200 obtains the radio signal, the intra-cabinet antenna 200 transmits the radio signal to the function node 100 connected to the intra-cabinet antenna 200, and the function node 100 determines whether the radio signal is data needed by the function node 100; and if not, the function node 100 transmits the radio signal to an intra-cabinet antenna 200 connected to the function node 100, and the connected intra-cabinet antenna 200 transmits the radio signal to an intra-cabinet antenna 200 that is vertically adjacent to the connected intra-cabinet antenna 200; or if yes, the function node 100 analyzes and processes the radio signal.

An embodiment of the present invention discloses a cabinet server. The cabinet server includes at least two function nodes, multiple intra-cabinet antennas, and multiple inter-cabinet antennas. The function nodes are vertically arranged, to form a server core, where the server core includes multiple function node layers, and each function node layer includes at least one function node. The intra-cabinet antennas are vertically arranged, disposed at a side of the server core, and electrically connected to corresponding function nodes, and adjacent intra-cabinet antennas are wirelessly connected.

When a radio signal is transmitted within a cabinet by using the cabinet server disclosed in this embodiment, after receiving a radio signal, an intra-cabinet antenna in the cabinet server transmits the radio signal to a vertically adjacent intra-cabinet antenna, so as to implement transmission of the radio signal between adjacent intra-cabinet antennas. A transmission path of the radio signal is formed of vertically arranged intra-cabinet antennas. Because intra-cabinet antennas are disposed at a side of a server core formed of function nodes, electromagnetic radiation generated by the radio signal in a transmission process has a relatively small effect on the function nodes, thereby reducing the effect of the electromagnetic radiation on various electronic devices in the function nodes, improving service lives of the electronic devices, and improving transmission quality of the radio signal.

Further, the cabinet server further includes a wireless data controller 400.

The wireless data controller 400 is disposed outside the server core and is connected to an intra-cabinet antenna 200 disposed at a top layer and an inter-cabinet antenna 300.

The wireless data controller 400 is generally disposed at a top of the server core. In addition, the wireless data controller 400 may be further disposed at the side of the server core. There is generally one wireless data controller 400, or there may be multiple wireless data controllers 400. When there are multiple wireless data controllers 400, the multiple wireless data controllers 400 are separately connected to different intra-cabinet antennas disposed at the top layer.

Each inter-cabinet antenna 300 is disposed at the top of the server core.

When the radio signal is transmitted between the cabinet server and another cabinet server, after obtaining the radio signal, the intra-cabinet antenna 200 disposed at the top layer transmits the radio signal to the wireless data controller 400, and the wireless data controller 400 transmits the radio signal to the connected inter-cabinet antenna 300.

The inter-cabinet antenna 300 is configured to receive the radio signal transmitted by the wireless data controller 400 and transmit the radio signal to the another cabinet server; and receive a radio signal transmitted by another cabinet server, and transmit, to the wireless data controller 400 connected to the inter-cabinet antenna 300, the radio signal transmitted by the another cabinet server, so that the wireless data controller 400 transmits, to the intra-cabinet antenna 200 at the top layer, the radio signal transmitted by the another cabinet server.

The wireless data controller 400 is configured to: after receiving a to-be-transmitted radio signal, control the inter-cabinet antenna 300 to transmit the radio signal to another cabinet server, or after receiving a radio signal transmitted by another cabinet server, the wireless data controller 400 controls an inter-cabinet antenna 300 to transmit the radio signal to an intra-cabinet antenna 200 disposed at the top, so that the intra-cabinet antenna 200 transmits a radio signal within the cabinet server.

The wireless data controller 400 transmits the data by using a corresponding scheduling strategy according to a data feature of the received radio signal. For example, when the wireless data controller 400 obtains a radio signal, the wireless data controller 400 performs an analysis according to a data feature of the radio signal; and when the radio signal needs to be transmitted between the cabinet server and another cabinet server, the wireless data controller 400 transmits the radio signal to the inter-cabinet antenna 300 and controls the inter-cabinet antenna 300 to transmit the radio signal to the another cabinet server; or when the radio signal needs to be transmitted within the cabinet server, the inter-cabinet antenna 300 transmits the radio signal to an intra-cabinet antenna 200, and transmission of the radio signal within the cabinet server is implemented by using the intra-cabinet antenna 200. The inter-cabinet antenna 300 is generally disposed at a top of the cabinet server. In addition, the inter-cabinet antenna 300 may be further disposed at two sides of the cabinet server.

When a radio signal is transmitted between different cabinet servers by using the cabinet server disclosed in the foregoing embodiment, an intra-cabinet antenna disposed at a top layer, a wireless data controller, and inter-cabinet antennas form a transmission path, and the radio signal does not pass through function nodes, thereby reducing an effect of electromagnetic radiation generated by the radio signal on various electronic devices in the function nodes, improving service lives of the electronic devices, and improving transmission quality of the radio signal.

Further, the cabinet server further includes a wireless shield layer 500.

The wireless shield layer 500 wraps the outside of the server core; and the intra-cabinet antennas 200, the inter-cabinet antennas 300, and the wireless data controller 400 are disposed outside the wireless shield layer 500.

The wireless shield layer 500 is generally made of a metal material. The intra-cabinet antennas 200, the inter-cabinet antennas 300, and the wireless data controller 400 are all disposed outside the wireless shield layer 500, and the server core including the function nodes 100 is disposed inside the wireless shield layer 500; therefore, when a radio signal is transmitted, the wireless shield layer can shield the electromagnetic radiation generated by the radio signal, thereby avoiding the effect of the electromagnetic radiation on various electronic devices in the server core, and further improving service lives of the electronic devices and transmission quality of the radio signal.

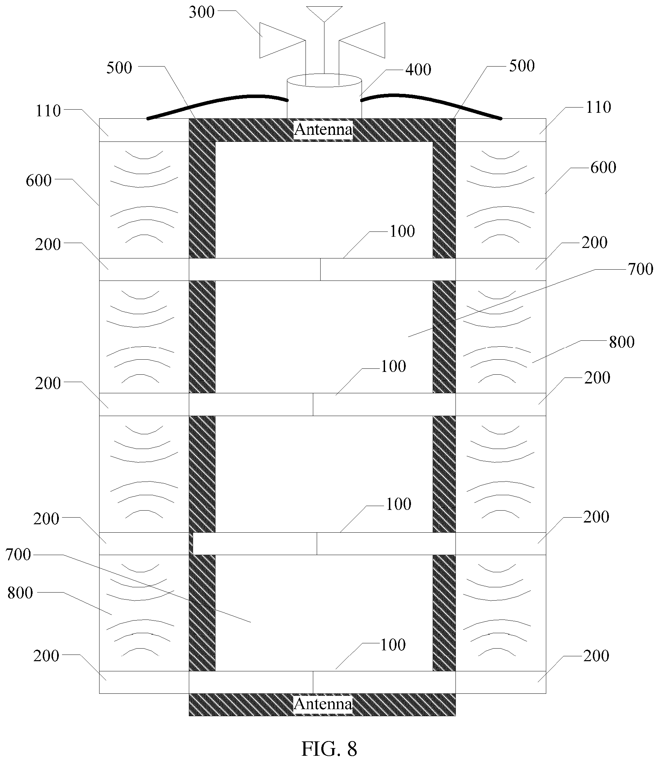

Referring to a side view of a cabinet server shown in FIG. 8, the cabinet server disclosed in this application further includes an antenna backplane 600.

The antenna backplane 600 is disposed outside the wireless shield layer 500 and configured to fasten the intra-cabinet antenna 200.

The antenna backplane 600 is generally disposed between the wireless shield layer 500 and a housing of the cabinet server. The intra-cabinet antenna 200 can be fastened by using the antenna backplane, and the antenna backplane 600 is generally made of a metal material, which not only can prevent leakage of a radio signal, but also can isolate radiation generated by a radio signal in another cabinet server.

In addition, the intra-cabinet antenna 200 can be further fastened in another form, for example, by using an internal fastening method. In this case, the cabinet server further includes an extension plate. The extension plate is disposed outside the wireless shield layer, is disposed in parallel with the function nodes, and is configured to fasten the intra-cabinet antenna. The extension plate may be a protruding structure disposed on the wireless shield layer 500, or an extension portion of the function node 100, and the wireless shield layer 500 is disposed between the function node 100 and the extension portion.

Further, in the cabinet server, a hollow cavity is formed between adjacent function nodes 100, and the hollow cavity may be referred to as a node cavity 700. Setting of the node cavity 700 helps the function node 100 perform heat dissipation, thereby improving a service life of the cabinet server. In the cabinet server disclosed in this embodiment of this application, if the intra-cabinet antenna 200 is fastened by means of the antenna backplane, when the node cavity 700 is formed between adjacent function nodes 100, an antenna cavity 800 is correspondingly formed between intra-cabinet antennas 200 correspondingly connected to the function nodes. Existence of the antenna cavity 800 helps improve heat sink performance of the cabinet server.

Further, in the cabinet server disclosed in this embodiment of this application, the intra-cabinet antenna 200 is connected to a corresponding function node 100 by using a microstrip.

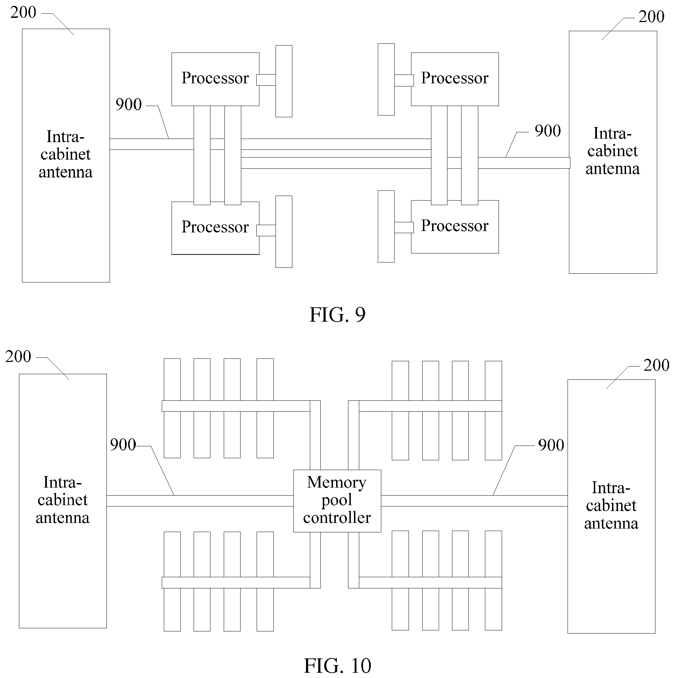

When the function nodes include a computing node and a memory node, separately refer to a schematic architectural diagram of the computing node shown in FIG. 9 and a schematic architectural diagram of the memory node shown in FIG. 10. Multiple processors are disposed in the computing node, and are connected to corresponding intra-cabinet antennas 200 by using microstrips 900. A memory pool controller and multiple memory modules connected to the memory pool controller are disposed inside the memory node, and the memory pool controller and the multiple memory modules are connected to corresponding intra-cabinet antennas 200 by using microstrips 900.

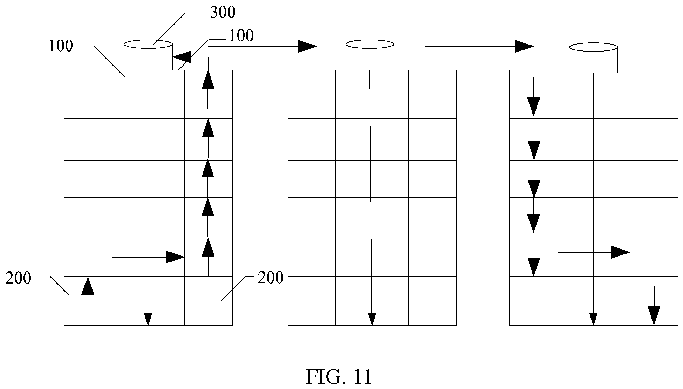

The microstrip has advantages of a small volume, being lightweight, use of a wide frequency band, high reliability, and low manufacturing costs, and can carry radio signals of different frequencies. Use of the microstrip helps the function node transmit a radio signal in a wireless frequency division multiplexing manner, thereby implementing path sharing and improving transmission efficiency. Refer to a schematic diagram of radio signal transmission shown in FIG. 11. When a cabinet server disclosed in this embodiment of this application transmits a radio signal, a first function node determines whether an obtained radio signal is needed by the first function node by using a method for address segment parsing and routing table query; and if yes, the first function node analyzes and processes the obtained radio signal; or if not, the first function node transmits the obtained radio signal to an intra-cabinet antenna connected to the first function node, the intra-cabinet antenna correspondingly connected to the first function node transmits the radio signal to a vertically adjacent intra-cabinet antenna, after receiving the radio signal, the vertically adjacent intra-cabinet antenna transmits the radio signal to a second function node correspondingly connected to the vertically adjacent intra-cabinet antenna, and the second function node correspondingly connected to the vertically adjacent intra-cabinet antenna determines whether the radio signal is needed by the second function node.

After a function node disposed at a top layer obtains a radio signal and knows by means of determining that the radio signal is not needed, an intra-cabinet antenna correspondingly connected to the function node at the top layer transmits the radio signal to a wireless data controller. The inter-cabinet antennas receive the radio signal transmitted by the wireless data controller, and transmit the radio signal to another cabinet server under control of the wireless data controller. After receiving the radio signal, a wireless data controller of the another cabinet server determines whether the radio signal is needed by the wireless data controller; and if not, the wireless data controller continues to transmit the radio signal to another cabinet server; or if yes, after receiving the radio signal, the another cabinet server transmits, by using an intra-cabinet antenna, the radio signal to a function node corresponding to the radio signal.

For example, when function nodes disposed in the server core from a bottom layer to a top layer are sequentially an I/O node, a storage node, a memory node, and a computing node, when the I/O node obtains a radio signal and knows by means of determining that the radio signal is not I/O data needed by the I/O node, the I/O node transmits the radio signal to a first intra-cabinet antenna connected to the I/O node. The first intra-cabinet antenna transmits the radio signal to a second intra-cabinet antenna correspondingly connected to the storage node, and then the second intra-cabinet antenna transmits the radio signal to the storage node. The storage node determines whether the radio signal is storage data needed by the storage node; and if yes, the storage node analyzes and processes the radio signal; or if not, the storage node transmits the radio signal to the second intra-cabinet antenna connected to the storage node. The second intra-cabinet antenna transmits the radio signal to a third intra-cabinet antenna correspondingly connected to the memory node. The third intra-cabinet antenna transmits the received radio signal to the memory node. The memory node determines whether the radio signal is memory data needed by the memory node, and if yes, the memory node analyzes and processes the radio signal; or if not, the memory node transmits the radio signal to a third inter-cabinet antenna, the third intra-cabinet antenna transmits the radio signal to a fourth intra-cabinet antenna connected to the computing node, and the fourth intra-cabinet antenna transmits the radio signal to the computing node. After receiving the radio signal, the computing node determines whether the radio signal is computing request data needed by the computing node; and if yes, the computing node parses and uses the radio signal; or if not, the computing node transmits the radio signal to the fourth intra-cabinet antenna. The fourth intra-cabinet antenna transmits the radio signal to a wireless data controller. The wireless data controller transmits the radio signal to an inter-cabinet antenna connected to the wireless data controller. Under scheduling of the wireless data controller, the inter-cabinet antenna transmits the radio signal to another cabinet server.

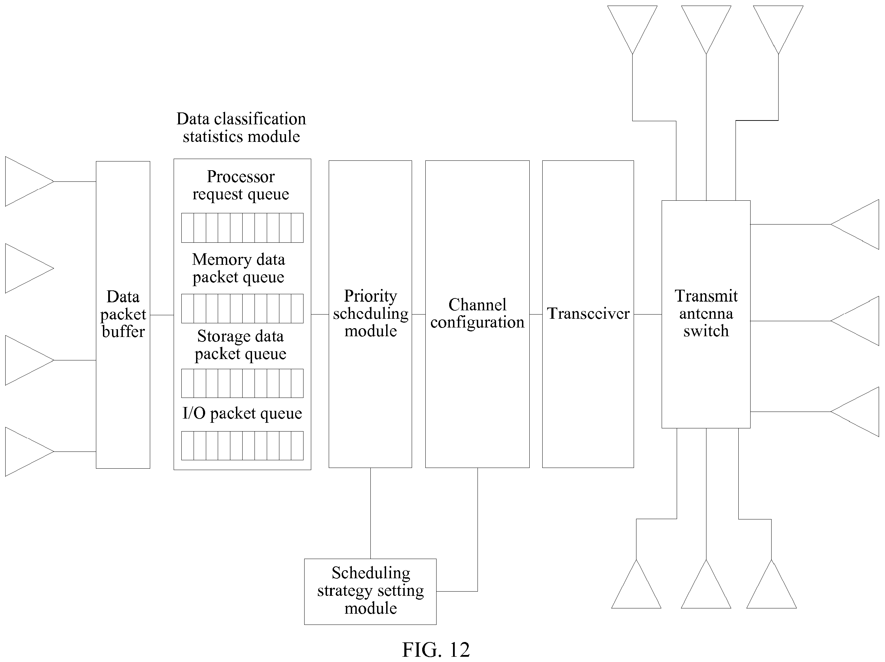

Refer to a schematic architectural diagram of a wireless data controller shown in FIG. 12. The wireless data controller receives a radio signal transmitted by an intra-cabinet antenna disposed at a top layer and places the radio signal into a data packet buffer module. The data packet buffer module transmits the radio signal to a data classification statistics module. The data classification statistics module classifies the radio signal according to a data feature of the radio signal and saves the radio signal into a corresponding queue. For example, when function nodes of a cabinet server are a computing node, a memory node, a storage node, and an I/O node, the radio signal may be saved into a processor request queue, a memory data packet queue, a storage data packet queue, or an I/O packet queue according to the data feature of the radio signal. Then, the data classification statistics module transmits the classified radio signal to a priority scheduling module, and the priority scheduling module obtains a scheduling strategy preset in a scheduling strategy setting module and then transmits the radio signal to a channel configuration module; then the channel configuration module transmits the radio signal to a transceiver; the transceiver transmits the radio signal to a transmit antenna switch; then the transmit antenna switch transmits the radio signal to a corresponding inter-cabinet antenna; and then, the inter-cabinet antenna transmits the radio signal to a corresponding cabinet server.

It can be learned through the foregoing radio signal transmission process that when a radio signal is transmitted within a cabinet server, a transmission path is formed of intra-cabinet antennas that are vertically adjacent to each other. All of the intra-cabinet antennas are connected to function nodes corresponding to the intra-cabinet antennas. Multiple layers of function nodes are generally included in the server core, and the multiple layers of function nodes and the intra-cabinet antennas are vertically arranged, thereby implementing vertical transmission of a radio signal.

In addition, referring to FIG. 3, when a wireless data center disclosed in the prior art performs radio signal intra-group transmission, a first intra-group communications element 21 generally transmits a radio signal to a second intra-group communications element in a form of an electromagnetic energy beam. An angle between the electromagnetic energy beam and a horizontal direction is α, which is used to represent a transverse diffusion range of the electromagnetic energy beam. In a transmission process, the electromagnetic energy beam encounters overlapping of radiation fields, which causes a transmission conflict. To reduce the transmission conflict and avoid deviation in a radiation field, the degree of the angle α needs to be controlled. Therefore, a radio signal needs to be transmitted by using a narrow lobe.

However, in this application, when a radio signal is transmitted in the foregoing manner, when transmitted between adjacent intra-cabinet antennas, the radio signal does not encounter overlapping of radiation fields, so that the radio signal can be transmitted in a form of a wide lobe, thereby improving transmission precision and efficiency.

Further, the cabinet server further includes a bottom inter-cabinet antenna disposed at a bottom of the server core; and a bottom wireless data controller that is disposed at the bottom of the server core and that is connected to the bottom inter-cabinet antenna, where the bottom wireless data controller is connected to a function node at a bottom layer.

The bottom wireless data controller is configured to: after receiving a radio signal transmitted by the function node at the bottom layer, transmit the radio signal to the bottom inter-cabinet antenna, so that the bottom inter-cabinet antenna transmit the radio signal to another cabinet server; and after receiving a radio signal transmitted by the bottom inter-cabinet antenna, transmit the radio signal to the bottom inter-cabinet antenna.

Refer to a schematic diagram of radio signal transmission shown in FIG. 11. When neither a bottom inter-cabinet antenna nor a bottom wireless data controller is disposed in a cabinet server, if a function node disposed at a bottom layer obtains a radio signal and the radio signal needs to be transmitted to another cabinet server, the radio signal needs to be sequentially transmitted by all layers of intra-cabinet antennas, so as to transmit the radio signal to an intra-cabinet antenna corresponding to a function node at a top layer. Then, the intra-cabinet antenna corresponding to the function node at the top layer transmits the radio signal to another cabinet server.

After a bottom inter-cabinet antenna and a bottom wireless data controller are disposed in the cabinet server, if a function node at a bottom layer of the cabinet server obtains a radio signal and the radio signal needs to be transmitted to another cabinet server, the function node at the bottom layer may transmit the radio signal to the bottom wireless data controller by using an intra-cabinet antenna connected to the function node. Under scheduling of the bottom wireless data controller, the bottom inter-cabinet antenna transmits the radio signal to the another cabinet server without a need of a process in which the radio signal is transmitted by using multiple layers of intra-cabinet antennas, which further shortens a transmission path of the radio signal, reduces a transmission delay, and improves a transmission speed of the radio signal.

Further, referring to FIG. 8, the cabinet server includes at least two function nodes 100, multiple intra-cabinet antennas 200, multiple inter-cabinet antennas 300, and a wireless data controller 400. Moreover, the cabinet server further includes rack top antennas 110.

The rack top antennas 110 are disposed above the intra-cabinet antenna disposed at the top layer, where the rack top antennas 110 and the intra-cabinet antennas 200 are vertically arranged, the rack top antennas 110 and the intra-cabinet antennas at the top layer are wirelessly connected, and the rack top antennas 110 and the wireless data controller 400 are connected.

The rack top antenna 110 is configured to receive a radio signal transmitted by the intra-cabinet antenna 200 at the top layer and transmit the radio signal to the wireless data controller 400; and receive a radio signal transmitted by the wireless data controller 400 and then transmit the radio signal to the intra-cabinet antenna 200 at the top layer.

The intra-cabinet antenna 200 disposed at the top layer and the rack top antenna 110 are generally connected in a wireless connection form. In addition, the rack top antenna 110 is generally connected to the wireless data controller 400 in a wired form. If no rack top antenna 110 is disposed in the cabinet server, the intra-cabinet antennas 200 disposed at the top layer are directly connected to the wireless data controller 400. When the radio signal needs to be transmitted to another cabinet server, after obtaining the radio signal, the intra-cabinet antenna 200 at the top layer transmits the radio signal to the connected wireless data controller 400, and the wireless data controller 400 controls the inter-cabinet antenna 300 to transmit the radio signal to the another cabinet server. Alternatively, after receiving a radio signal transmitted by another cabinet server, the inter-cabinet antenna 300 transmits the radio signal to the intra-cabinet antenna 200 at the top layer by using the wireless data controller 400, and the intra-cabinet antenna 200 at the top layer transmits the radio signal within the cabinet server.

After the rack top antennas 110 are disposed in the cabinet server, the rack top antennas 110 are connected to the wireless data controller 400, and the rack top antennas 110 are used as a radio signal transmission medium between the intra-cabinet antennas 200 at the top layer and the wireless data controller 400. The wireless data controller 400 transmits the radio signal to the intra-cabinet antenna at the top layer by using the rack top antenna 110, or the intra-cabinet antenna at the top layer transmits the radio signal to the wireless data controller 400 by using the rack top antenna 110. By means of setting of the rack top antennas 110, a radio signal transmission medium is added, which facilitates improvement of radio signal transmission quality.

Correspondingly, this application further discloses a data center. The data center includes the cabinet server described above.

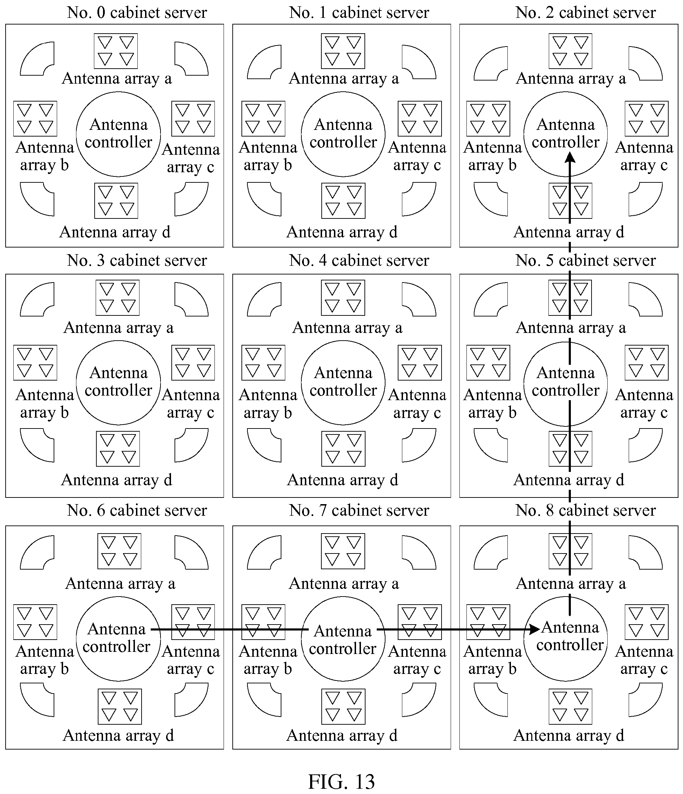

In the data center, adjacent cabinet servers are wirelessly connected by using an inter-cabinet antenna. Referring to a schematic architectural diagram of a data center shown in FIG. 13, the data center includes multiple cabinet servers, where the cabinet servers implement radio signal inter-cabinet transmission by using a wireless connection formed by inter-cabinet antennas. For example, when a No. 6 cabinet server needs to transmit a radio signal to a No. 2 cabinet server, a transmission path from the No. 6 cabinet server to a No. 7 cabinet server to a No. 8 cabinet server to a No. 5 cabinet server to the No. 2 cabinet server may be made according to a current occupied degree of each cabinet server. Certainly, another transmission path may be further made, which is not limited in this application.

In addition, in the data center, a housing of the cabinet server may be set to have multiple shapes. Generally, the housing is set to be square. Relative to a structure in another shape, a square structure has a relatively large available volume, and more devices can be deployed in the square structure. In the data center, the multiple cabinet servers are generally formed into a form of a square matrix, which facilitates radio signal transmission.

In the data center, used inter-cabinet antennas are generally directional antennas. Directional antennas in a same direction form an antenna array. When a radio signal is transmitted by using the directional antennas, a signal strength can be enhanced and an anti-interference capability can be improved.

A person skilled in the art may clearly understand that, the technologies in the embodiments of the present invention may be implemented by software in addition to a necessary general hardware platform. Based on such an understanding, the technical solutions of the present invention essentially or the part contributing to the prior art may be implemented in a form of a software product. The software product is stored in a storage medium, such as a ROM/RAM, a hard disk, or an optical disc, and includes several instructions for instructing a computer device (which may be a personal computer, a server, or a network device) to perform the methods described in the embodiments or some parts of the embodiments of the present invention.

The embodiments in this specification are all described in a progressive manner, for same or similar parts in the embodiments, reference may be made to these embodiments, and each embodiment focuses on a difference from other embodiments. Especially, a system embodiment is basically similar to a method embodiment, and therefore is described briefly; for related parts, reference may be made to partial descriptions in the method embodiment.

It should be noted that in this specification, relational terms such as first and second are only used to distinguish one entity or operation from another, and do not necessarily require or imply that any actual relationship or sequence exists between these entities or operations. Moreover, the terms "include", "include", or their any other variant is intended to cover a non-exclusive inclusion, so that a process, a method, an article, or an apparatus that includes a list of elements not only includes those elements but also includes other elements which are not expressly listed, or further includes elements inherent to such process, method, article, or apparatus. An element preceded by "includes a ..." does not, without more constraints, preclude the existence of additional identical elements in the process, method, article, or apparatus that includes the element.

## Claims

1. A cabinet server, wherein the cabinet server comprises at least two function nodes (100), multiple intra-cabinet antennas (200), and multiple inter-cabinet antennas (300), wherein
the function nodes (100) are vertically arranged, to form a server core, wherein the server core comprises multiple function node layers, and each function node layer comprises at least one function node (100);
the intra-cabinet antennas (200) are vertically arranged and are disposed at a side of the server core, an intra-cabinet antenna (200) corresponding to each function node (100) has a frequency needed by the corresponding function node (100), the intra-cabinet antenna (200) and the corresponding function node (100) are electrically connected, and adjacent intra-cabinet antennas (200) are wirelessly connected; and
when a radio signal is transmitted within the cabinet server, each intra-cabinet antenna (200) is configured to transmit, after receiving the radio signal, the radio signal to a vertically adjacent intra-cabinet antenna (200), until the radio signal is transmitted to a target intra-cabinet antenna (200) of the multiple intra-cabinet antennas (200), and the target intra-cabinet antenna (200) transmits the radio signal to a function node (100) that is electrically connected to the target intra-cabinet antenna (200), so that the function node (100) analyzes and processes the radio signal, and
wherein a hollow cavity (700) is formed between adjacent function nodes (100), and
the radio signal is transmitted in a form of a wide lobe.

2. The cabinet server according to claim 1, wherein the cabinet server further comprises a wireless data controller (400), and the wireless data controller (400) is disposed outside the server core and is connected to an intra-cabinet antenna (200) disposed at a top layer and an inter-cabinet antenna (300);
each inter-cabinet antenna (300) is disposed at a top of the server core;
when the radio signal is transmitted between the cabinet server and another cabinet server, after obtaining the radio signal, the intra-cabinet antenna (200) disposed at the top layer transmits the radio signal to the wireless data controller (400), and the wireless data controller (400) transmits the radio signal to the connected inter-cabinet antenna (300); and
the inter-cabinet antenna (300) is configured to receive the radio signal transmitted by the wireless data controller (400) and transmit the radio signal to the another cabinet server; and receive a radio signal transmitted by another cabinet server, and transmit, to the wireless data controller (400) connected to the inter-cabinet antenna (300), the radio signal transmitted by the another cabinet server, so that the wireless data controller (400) transmits, to the intra-cabinet antenna (200) at the top layer, the radio signal transmitted by the another cabinet server.

3. The cabinet server according to claim 2, wherein the cabinet server further comprises:
a wireless shield layer (500), wherein the wireless shield layer wraps the outside of the server core; and
the intra-cabinet antennas (200), the inter-cabinet antennas (300), and the wireless data controller (400) are disposed outside the wireless shield layer (500).

4. The cabinet server according to claim 3, wherein the cabinet server further comprises:
an antenna backplane (600), wherein the antenna backplane (600) is disposed outside the wireless shield layer (500) and configured to fasten the intra-cabinet antenna (200).

5. The cabinet server according to claim 3, wherein the cabinet server further comprises:
an extension plate, wherein the extension plate is disposed outside the wireless shield layer (500), is disposed in parallel with the function nodes (100), and is configured to fasten the intra-cabinet antenna (200).

6. The cabinet server according to claim 1, wherein the function nodes (100) comprise:
a computing node, a memory node, a storage node, and an input/output node.

7. The cabinet server according to claim 2, wherein the cabinet server further comprises:
a bottom inter-cabinet antenna disposed at a bottom of the server core; and
a bottom wireless data controller that is disposed at the bottom of the server core and that is connected to the bottom inter-cabinet antenna, wherein the bottom wireless data controller is connected to a function node at a bottom layer; and
the bottom wireless data controller is configured to: after receiving a radio signal transmitted by the function node at the bottom layer, transmit the radio signal to the bottom inter-cabinet antenna, so that the bottom inter-cabinet antenna transmit the radio signal to another cabinet server; and after receiving a radio signal transmitted by the bottom inter-cabinet antenna, transmit the radio signal to the function node at the bottom layer.

8. The cabinet server according to any one of claims 2 to 7, wherein the cabinet server further comprises:
rack top antennas (110) disposed above the intra-cabinet antenna (200) disposed at the top layer, wherein the rack top antennas (110) and the intra-cabinet antennas (200) are vertically arranged, the rack top antennas (110) and the intra-cabinet antennas (200) at the top layer are wirelessly connected, and the rack top antennas (110) and the wireless data controller (400) are connected; and
the rack top antenna (110) is configured to receive a radio signal transmitted by the intra-cabinet antenna (200) at the top layer and transmit the radio signal to the wireless data controller (400); and receive a radio signal transmitted by the wireless data controller (400) and then transmit the radio signal to the intra-cabinet antenna (200) at the top layer.

9. A data center, wherein the data center comprises:
the cabinet server according to any one of claims 1 to 8.

10. The data center according to claim 9, wherein
in the data center, adjacent cabinet servers are wirelessly connected by using an inter-cabinet antenna (300).

## Patentansprüche

1. Schrank-Server, wobei der Schrank-Server wenigstens zwei Funktionsknoten (100), mehrere schrankinterne Antennen (200) und mehrere Zwischenschrankantennen (300) umfasst, wobei
die Funktionsknoten (100) vertikal angeordnet sind, um einen Server-Kern zu bilden, wobei der Server-Kern mehrere Funktionsknotenschichten umfasst und jede Funktionsknotenschicht wenigstens einen Funktionsknoten (100) umfasst;
die schrankinternen Antennen (200) vertikal angeordnet sind und auf einer Seite des Server-Kerns angeordnet sind, wobei eine schrankinterne Antenne (200), die jedem Funktionsknoten (100) entspricht, eine Frequenz aufweist, die durch den entsprechenden Funktionsknoten (100) benötigt wird, die schrankinterne Antenne (200) und der entsprechende Funktionsknoten (100) elektrisch verbunden sind und benachbarte schrankinterne Antennen (200) drahtlos verbunden sind; und
jede schrankinterne Antenne (200) dann, wenn ein Funksignal innerhalb des Schrank-Servers gesendet wird, konfiguriert ist, nach dem Empfangen des Funksignals das Funksignal an eine vertikal benachbarte schrankinterne Antenne (200) zu senden, bis das Funksignal an eine schrankinterne Zielantenne (200) der mehreren schrankinternen Antennen (200) gesendet wird, wobei die schrankinterne Zielantenne (200) das Funksignal an einen Funktionsknoten (100) sendet, der mit der schrankinternen Zielantenne (200) elektrisch verbunden ist, so dass der Funktionsknoten (100) das Funksignal analysiert und verarbeitet, und
wobei ein hohler Hohlraum (700) zwischen benachbarten Funktionsknoten (100) ausgebildet ist und
das Funksignal in Form einer breiten Strahlungskeule gesendet wird.

2. Schrank-Server nach Anspruch 1, wobei der Schrank-Server ferner einen drahtlosen Daten-Controller (400) umfasst und der drahtlose Daten-Controller (400) außerhalb des Server-Kerns angeordnet ist und mit einer schrankinternen Antenne (200), die in einer oberen Schicht angeordnet ist, und einer Zwischenschrankantenne (300) verbunden ist;
jede Zwischenschrankantenne (300) an einem Oberteil des Server-Kerns angeordnet ist;
wenn das Funksignal zwischen dem Schrank-Server und einem weiteren Schrank-Server gesendet wird, die schrankinterne Antenne (200), die in einer oberen Schicht angeordnet ist, nach dem Erhalten des Funksignals das Funksignal an den drahtlosen Daten-Controller (400) sendet und der drahtlose Daten-Controller (400) das Funksignal an die angeschlossene Zwischenschrankantenne (300) sendet; und
die Zwischenschrankantenne (300) konfiguriert ist, das durch den drahtlosen Daten-Controller (400) gesendete Funksignal zu empfangen und das Funksignal an den weiteren Schrank-Server zu senden; und ein durch den weiteren Schrank-Server gesendetes Funksignal zu empfangen und das durch den weiteren Schrank-Server gesendete Funksignal an den drahtlosen Daten-Controller (400), der mit der Zwischenschrankantenne (400) verbunden ist, zu senden, so dass der drahtlose Daten-Controller (400) das durch den weiteren Schrank-Server gesendete Funksignal an die schrankinterne Antenne (200) in der oberen Schicht sendet.

3. Schrank-Server nach Anspruch 2, wobei der Schrank-Server ferner Folgendes umfasst:
eine drahtlose Abschirmschicht (500), wobei die drahtlose Abschirmschicht das Äußere des Server-Kerns umhüllt; und
die schrankinternen Antennen (200), die Zwischenschrankantennen (300) und der drahtlose Daten-Controller (400) außerhalb der drahtlosen Abschirmschicht (500) angeordnet sind.

4. Schrank-Server nach Anspruch 3, wobei der Schrank-Server ferner Folgendes umfasst:
eine Antennenrückplatte (600), wobei die Antennenrückplatte (600) außerhalb der drahtlosen Abschirmschicht (500) angeordnet ist und konfiguriert ist, die schrankinterne Antenne (200) zu befestigen.

5. Schrank-Server nach Anspruch 3, wobei der Schrank-Server ferner Folgendes umfasst:
eine Erweiterungsplatte, wobei die Erweiterungsplatte außerhalb der drahtlosen Abschirmschicht (500) angeordnet ist, zu den Funktionsknoten (100) parallel angeordnet ist und konfiguriert ist, die schrankinterne Antenne (200) zu befestigen.

6. Schrank-Server nach Anspruch 1, wobei die Funktionsknoten (100) Folgendes umfassen:
einen Rechenknoten, einen Datenspeicherknoten, einen Speicherknoten und einen Eingabe-/Ausgabeknoten.

7. Schrank-Server nach Anspruch 2, wobei der Schrank-Server ferner Folgendes umfasst:
eine untere Zwischenschrankantenne, die an einem Boden des Server-Kerns angeordnet ist; und
einen unteren drahtlosen Daten-Controller, der am Boden des Server-Kerns angeordnet ist und der mit der unteren Zwischenschrankantenne verbunden ist, wobei der untere drahtlose Daten-Controller mit einem Funktionsknoten in einer unteren Schicht verbunden ist; und
der untere drahtlose Daten-Controller konfiguriert ist: nach dem Empfangen eines durch den Funktionsknoten in der unteren Schicht gesendeten Funksignals das Funksignal an die untere Zwischenschrankantenne zu senden, so dass die untere Zwischenschrankantenne das Funksignal an einen weiteren Schrank-Server sendet; und nach dem Empfangen eines durch die untere Zwischenschrankantenne gesendeten Funksignals das Funksignal an den Funktionsknoten in der unteren Schicht zu senden.

8. Schrank-Server nach einem der Ansprüche 2 bis 7, wobei der Schrank-Server ferner Folgendes umfasst:
obere Gestellantennen (110), die über der schrankinternen Antenne (200), die in der oberen Schicht angeordnet ist, angeordnet sind, wobei die oberen Gestellantennen (110) und die schrankinternen Antennen (200) vertikal angeordnet sind, die oberen Gestellantennen (110) und die schrankinternen Antennen (200) in der oberen Schicht drahtlos verbunden sind und die oberen Gestellantennen (110) und der drahtlose Daten-Controller (400 verbunden sind; und
die obere Gestellantenne (110) konfiguriert ist, ein durch die schrankinterne Antenne (200) in der oberen Schicht gesendetes Funksignal zu empfangen und das Funksignal an den drahtlosen Daten-Controller (400) zu senden; und ein durch den drahtlosen Daten-Controller (400) gesendetes Funksignal zu empfangen und dann das Funksignal an die schrankinterne Antenne (200) in der oberen Schicht zu senden.

9. Datenzentrum, wobei das Datenzentrum Folgendes umfasst:
den Schrank-Server nach einem der Ansprüche 1 bis 8.

10. Datenzentrum nach Anspruch 9, wobei
in dem Datenzentrum benachbarte Schrank-Server unter Verwendung einer Zwischenschrankantenne (300) drahtlos verbunden sind.

## Revendications

1. Serveur-armoire, le serveur-armoire comprenant au moins deux nœuds de fonction (100), de multiples antennes intra-armoires (200) et de multiples antennes interarmoires (300),
les nœuds de fonction (100) étant agencés verticalement pour former un noyau de serveur, le noyau de serveur comprenant de multiples couches de nœuds de fonction et chaque couche de nœuds de fonction comprenant au moins un nœud de fonction (100) ; les antennes intra-armoires (200) étant agencées verticalement et étant disposées au niveau d'un côté du noyau de serveur, une antenne intra-armoire (200) qui correspond à chaque nœud de fonction (100) ayant une fréquence requise par le nœud de fonction (100) correspondant, l'antenne intra-armoire (200) et le nœud de fonction (100) correspondant étant connectés électriquement et des antennes intra-armoires (200) adjacentes étant connectées sans fil ; et
quand un signal radio est transmis dans le serveur-armoire, chaque antenne intra-armoire (200) étant configurée pour transmettre, après la réception du signal radio, le signal radio à une antenne intra-armoire (200) verticalement adjacente jusqu'à ce que le signal radio soit transmis à une antenne intra-armoire (200) cible des multiples antennes intra-armoires (200), et l'antenne intra-armoire (200) cible transmettant le signal radio à un nœud de fonction (100) qui est connecté électriquement à l'antenne intra-armoire (200) cible, de sorte que le nœud de fonction (100) analyse et traite le signal radio, et
une cavité creuse (700) étant formée entre des nœuds de fonction (100) adjacents et le signal radio étant transmis sous la forme d'un lobe large.

2. Serveur-armoire selon la revendication 1, le serveur-armoire comprenant en outre un contrôleur de données sans fil (400) et le contrôleur de données sans fil (400) étant disposé à l'extérieur du noyau de serveur et étant connecté à une antenne intra-armoire (200) disposée au niveau d'une couche supérieure et à une antenne interarmoire (300) ;
chaque antenne interarmoire (300) étant disposée en haut du noyau de serveur ; quand le signal radio est transmis entre le serveur-armoire et un autre serveur-armoire, après l'obtention du signal radio, l'antenne intra-armoire (200) disposée au niveau de la couche supérieure transmettant le signal radio au contrôleur de données sans fil (400) et le contrôleur de données sans fil (400) transmettant le signal radio à l'antenne interarmoire (300) connectée ; et
l'antenne interarmoire (300) étant configurée pour recevoir le signal radio transmis par le contrôleur de données sans fil (400) et transmettre le signal radio à l'autre serveur-armoire ; et pour recevoir un signal radio transmis par un autre serveur-armoire et transmettre, au contrôleur de données sans fil (400) connecté à l'antenne interarmoire (300), le signal radio transmis par l'autre serveur-armoire, de sorte que le contrôleur de données sans fil (400) transmette, à l'antenne intra-armoire (200) au niveau de la couche supérieure, le signal radio transmis par l'autre serveur-armoire.

3. Serveur-armoire selon la revendication 2, le serveur-armoire comprenant en outre :
une couche de blindage sans fil (500), la couche de blindage sans fil enveloppant l'extérieur du noyau de serveur ; et
les antennes intra-armoires (200), les antennes interarmoires (300) et le contrôleur de données sans fil (400) étant disposés à l'extérieur de la couche de blindage sans fil (500).

4. Serveur-armoire selon la revendication 3, le serveur-armoire comprenant en outre :
un fond de panier d'antenne (600), le fond de panier d'antenne (600) étant disposé à l'extérieur de la couche de blindage sans fil (500) et configuré pour fixer l'antenne intra-armoire (200).

5. Serveur-armoire selon la revendication 3, le serveur-armoire comprenant en outre :
une plaque d'extension, la plaque d'extension étant disposée à l'extérieur de la couche de blindage sans fil (500), étant disposée parallèlement aux nœuds de fonction (100) et étant configurée pour fixer l'antenne intra-armoire (200).

6. Serveur-armoire selon la revendication 1, dans lequel les nœuds de fonction (100) comprennent :
un nœud informatique, un nœud mémoire, un nœud de stockage et un nœud d'entrée/sortie.

7. Serveur-armoire selon la revendication 2, le serveur-armoire comprenant en outre :
une antenne interarmoire inférieure disposée en bas du noyau de serveur ; et
un contrôleur de données sans fil inférieur qui est disposé en bas du noyau de serveur et qui est connecté à l'antenne interarmoire inférieure, le contrôleur de données sans fil inférieur étant connecté à un nœud de fonction au niveau d'une couche inférieure ; et
le contrôleur de données sans fil inférieur étant configuré pour : après la réception d'un signal radio transmis par le nœud de fonction au niveau de la couche inférieure, transmettre le signal radio à l'antenne interarmoire inférieure, de sorte que l'antenne interarmoire inférieure transmette le signal radio à un autre serveur-armoire ; et après la réception d'un signal radio transmis par l'antenne interarmoire inférieure, transmettre le signal radio au nœud de fonction au niveau de la couche inférieure.

8. Serveur-armoire selon l'une quelconque des revendications 2 à 7, le serveur-armoire comprenant en outre :
des antennes supérieures de baie (110) disposées au-dessus de l'antenne intra-armoire (200) disposée au niveau de la couche supérieure, les antennes supérieures de baie (110) et les antennes intra-armoires (200) étant agencées verticalement, les antennes supérieures de baie (110) et les antennes intra-armoires (200) au niveau de la couche supérieure étant connectées sans fil et les antennes supérieures de baie (110) et le contrôleur de données sans fil (400) étant connectés ; et
l'antenne supérieure de baie (110) étant configurée pour recevoir un signal radio transmis par l'antenne intra-armoire (200) au niveau de la couche supérieure et transmettre le signal radio au contrôleur de données sans fil (400) ; et pour recevoir un signal radio transmis par le contrôleur de données sans fil (400) puis transmettre le signal radio à l'antenne intra-armoire (200) au niveau de la couche supérieure.

9. Centre de données, le centre de données comprenant :
le serveur-armoire selon l'une quelconque des revendications 1 à 8.

10. Centre de données selon la revendication 9, dans lequel :
dans le centre de données, des serveurs-armoires adjacents sont connectés sans fil au moyen d'une antenne interarmoire (300).
